Europäisches Patentamt

European Patent Office

Office européen des brevets

(11) Numéro de publication: **0 338 914 B1**

(12) **FASCICULE DE BREVET EUROPEEN**

(45) Date de publication de fascicule du brevet: **16.03.94** (51) Int. Cl.5: **C30B 11/00**, C30B 35/00

(21) Numéro de dépôt: **89401067.7**

(22) Date de dépôt: **18.04.89**

(54) **Procédé et creuset de solidification de matériaux, et application à la cristallogénèse de semi-conducteurs.**

(30) Priorité: **20.04.88 FR 8805221**

(43) Date de publication de la demande:
**25.10.89 Bulletin 89/43**

(45) Mention de la délivrance du brevet:
**16.03.94 Bulletin 94/11**

(84) Etats contractants désignés:
**CH DE FR GB IT LI NL SE**

(56) Documents cités:
**EP-A- 0 151 863**
**FR-A- 1 420 234**
**FR-A- 2 344 332**
**FR-A- 2 345 253**

(73) Titulaire: **COMMISSARIAT A L'ENERGIE ATO-MIOUE**
**31/33, rue de la Fédération**
**F-75015 Paris Cédex 15(FR)**

Titulaire: **CENTRE NATIONAL D'ETUDES SPA-TIALES**
**2 Place Maurice-Ouentin**
**F-75039 Paris Cedex 01(FR)**

(72) Inventeur: **Duffar, Thierry**
**2, rue de Mortillet**
**F-38000 Grenoble(FR)**
Inventeur: **Dusserre, Pierre**
**24, rue Chapotier**
**F-38120 Saint Egreve(FR)**

(74) Mandataire: **Mongrédien, André et al**
**c/o BREVATOME**
**25, rue de Ponthieu**
**F-75008 Paris (FR)**

Rank Xerox (UK) Business Services
(3.10/3.09/3.3.3)

**Description**

Le domaine de l'invention est l'élaboration de matériaux solides par solidification du même matériau à l'état liquide, et en particulier en vue de produire des semi-conducteurs par cristallogénèse du matériau liquide. L'invention concerne à la fois un procédé et un creuset de solidification et la fabrication de semi-conducteurs.

Pour l'élaboration de certains matériaux solides, et en particulier les semi-conducteurs, les phénomènes physiques sont tels que, jusqu'à présent, seule la cristallogénèse au sol est utilisée. La cristallogénèse dans l'espace est envisagée pour l'obtention de cristaux de meilleure qualité qu'au sol. On dénombre plusieurs techniques de solidification de semi-conducteurs dans l'espace, au moyen de creusets, et qui sont : une première méthode dite de BRIDGMAN, une deuxième méthode dite "de fusion de zones" en creusets, et une troisième méthode utilisant la croissance en solution. Le principe de base de toutes ces méthodes revient à fondre tout ou partie de la matière dans un creuset et, soit en déplaçant un creuset dans un champ thermique, soit en déplaçant le champ thermique par rapport au creuset, à resolidifier lentement et directionnellement le matériau. Les principales qualités à obtenir sont la monocristallinité et la qualité structurale, c'est-à-dire peu de dislocation, la teneur en dopants électroniques, la pureté chimique et d'autres caractéristiques électroniques.

Les principaux défauts liés à cette technique sont connus depuis longtemps. En particulier, le liquide est en contact, à une température très élevée, avec les parois du creuset, ce qui entraîne des pollutions chimiques. De plus, les interactions entre le cristal et le creuset peuvent générer des défauts cristallins, tels que les dislocations par collage ou par dilatation différentielle. Au niveau de l'interface liquide-solide, le creuset peut générer des pertes d'orientation cristalline, ainsi que des perturbations thermiques nuisibles à la cristallogénèse.

Ces problèmes sont évoqués dans le brevet américain 4 169 755 puisqu'il décrit une méthode de fabrication d'une pièce en matériau cristallin au moyen d'un creuset. La solution qu'apporte ce brevet consiste à intercaler entre le matériau et la paroi du creuset une couche de gallium.

Selon FR-A-2345 253, une autre solution consiste à intercaler un mince matelas fibreux en matière réfractaire entre le matériau à solidifier et la paroi du creuset.

Le but de l'invention est de proposer une autre solution n'utilisant pas de produit intermédiaire entre la paroi et le matériau à cristalliser. L'invention vise aussi à éviter la méthode de solidification sans contact utilisée dans l'espace. En effet, cette méthode permet l'absence de convection thermique qui, au sol, perturbe fortement l'homogénéité chimique du cristal. Une idée de solidifier ces corps sans contact avec un creuset s'avère donc séduisante, puisque, dans l'espace, les matériaux liquides sont en lévitation et solidifiés sous forme de sphères. Malheureusement, deux inconvénients supplémentaires apparaissent alors : les sphères ne sont pas des formes géométriques permettant une utilisation ultérieure aisée du semi-conducteur, et les surfaces libres du liquide, soumises à un gradient thermique, sont le siège d'un mouvement de convection de surface dû à la variation de la tension superficielle avec la température. On perd alors tous les avantages de la cristallogénèse en absence de gravité. Le but de l'invention consiste donc également à utiliser des méthodes avec creusets, tout en évitant les inconvénients cités plus haut, en particulier les contraintes mécaniques exercées sur le cristal par l'attachement aux parois du creuset.

Dans ce but, un premier objet principal de l'invention est un procédé de solidification d'un matériau liquide, tel que la cristallogénèse de semi-conducteurs, dans un creuset. Le procédé selon la revendication 1 se caractérise notamment en ce que l'on réalise :

(a) un mouillage composite entre les liquides et le creuset, et

(b) un démouillage du creuset lors de la solidification, assurant ainsi le décollement complet, par rapport à la paroi du creuset, du cristal solidifié à partir du liquide. Les contacts du matériau avec les parois du creuset disparaissant presque totalement, les contraintes mécaniques exercées par ces parois sur le matériau disparaissent proportionnellement à ce décollement.

De manière plus précise, le matériau à solidifier ayant un angle de croissance (A) déterminé, et la rugosité une fréquence (L), l'intégration de l'équation suivante :

$$\frac{dy}{dx}\left(1 - \frac{y}{x-L} + tgA\right) - \frac{y}{x-L} + tgA = 0$$

définit la forme de la surface libre du matériau solidifié.

On prévoit, dans une première réalisation du procédé selon l'invention, où il y a une faible pression hydrostatique du liquide et où un angle de mouillage existe entre le liquide et la paroi du creuset, que l'angle de la rugosité de la paroi interne du creuset est inférieur à l'angle de mouillage diminué d'un angle égal à $\pi/2$.

Dans d'autres cas, l'angle de la rugosité (R) est égal à l'angle de mouillage (T) diminué de $\pi/2$ et de l'angle (B) défini par la formule suivante :

$$\sin B = \frac{L}{2C},$$

C étant le rayon de courbure de la surface liquide.

Le matériau constituant le creuset, la forme et la rugosité des parois de ce dernier sont donc choisis en fonction du matériau liquide à solidifier.

Un deuxième objet principal de l'invention est un creuset tel que défini à la revendication 3 ou 4 pour la mise en oeuvre du procédé tel qu'il est décrit dans les deux paragraphes précédents. Ce creuset comprend des parois dont la rugosité est définie par un angle de rugosité par rapport à la normale à la surface macroscopique de la paroi, égal à l'angle de mouillage diminué d'un angle égal à $\pi/2$, dans le cas d'une faible pression hydrostatique du liquide.

Une application de l'invention est prévue pour la cristallogénèse des semi-conducteurs.

L'invention et ses différentes caractéristiques seront mieux comprises à la lecture de la description qui suit et qui est annexée des figures suivantes :
- Figure 1, un schéma montrant le phénomène de mouillage d'un liquide sur un solide.
- Figure 2, un schéma montrant le phénomène de l'angle de croissance, lors de la solidification d'un liquide.
- Figures 3A et 3B, deux schémas expliquant le phénomène de mouillage composite en microgravité et en gravité.
- Figures 4A à 4E, des schémas relatifs aux phénomènes de solidification utilisés dans le procédé et le creuset selon l'invention.
- Figure 5, un schéma relatif aux résultats obtenus par l'utilisation du procédé et du creuset selon l'invention.

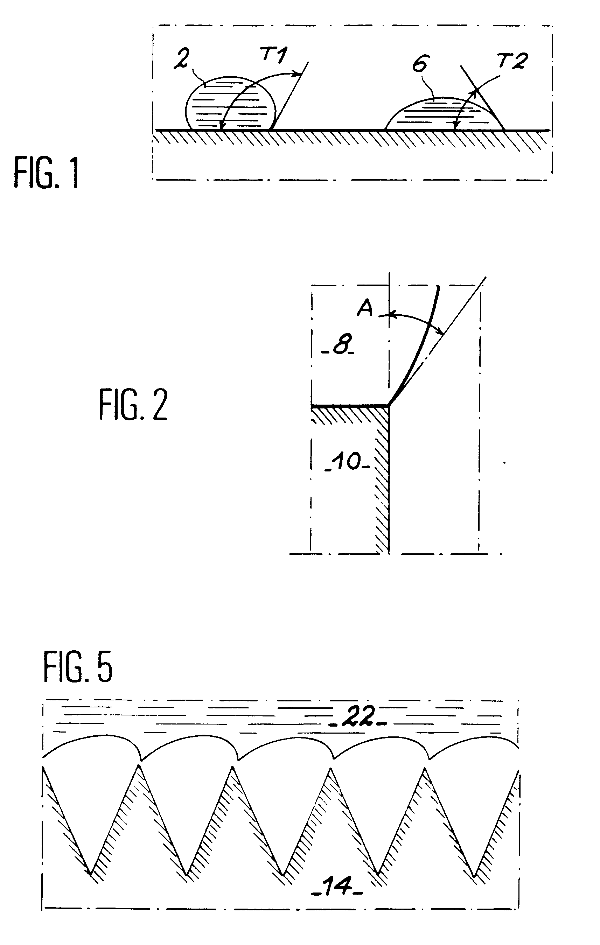

En référence à la figure 1, et en présence de gravité, une petite quantité de liquide, tel qu'une goutte 2, 6, posée sur un substrat 4, s'étale sur celui-ci. Cette goutte affecte une forme déterminée délimitée par une surface. L'angle que fait cette surface à l'endroit où elle est en contact avec le substrat, est appelé angle de mouillage, repéré ici T1 et T2. On voit que sur la gauche, la goutte de liquide est ramassée et l'angle de mouillage T1 est important. Par contre, sur la droite de la figure, la goutte 6 est beaucoup plus étalée et l'angle de mouillage T2 est plus petit, et inférieur à $\pi/2$. Cette valeur d'angle de mouillage T est caractéristique du couple liquide-solide en présence. Cet angle varie très faiblement en fonction des conditions thermodynamiques, telles que la pression et la température.

En référence maintenant à la figure 2, dans le cas particulier d'un liquide mouillant son propre solide, il existe également un angle de mouillage. On évoquera ici le cas particulier au cours duquel il y a solidification du liquide 8 en solide 10. Cet angle A est toujours présent entre la face libre du solide 10 et la tangente à la surface libre du liquide 8, à l'endroit de l'interface de solidification solide-liquide, et ceci quelles que soient les conditions thermiques. Dans ce cas, on parle d'angle de croissance A des corps à solidifier.

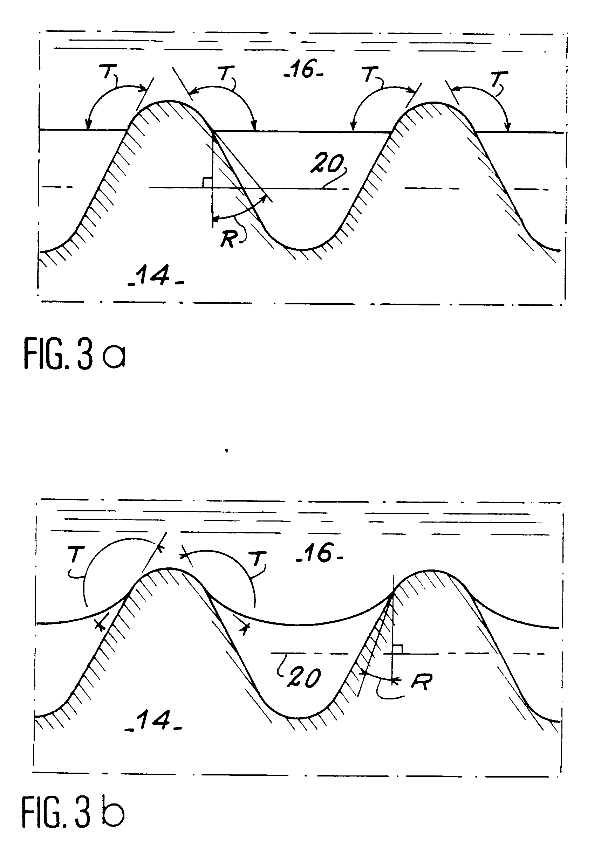

Les figures 3A et 3B évoquent maintenant la paroi interne d'un creuset, mise en contact avec un liquide 16. Cette figure visualise l'angle de mouillage T du liquide 16 en contact avec certains endroits de la paroi 14. Lorsque cette dernière est composée de fortes rugosités, représentées ici par une courbe ressemblant à une sinusoïde, on est en présence d'un phénomène appelé mouillage composite. Compte tenu de la présence de cet angle de mouillage T qui a été représenté ici supérieur à un angle égal à $\pi/2$, il est impossible que ce liquide pénètre jusqu'au fond de la rugosité, si cet angle maximal R de la rugosité par rapport à la verticale est tel que :

$R < T - \frac{\pi}{2}$    (équation 1)

La figure 3A montre ce phénomène de mouillage composite en présence de microgravité. Sur le sol terrestre, on est plutôt en présence de gravité, ce cas étant représenté par la figure 3B. La surface libre 18 du liquide 16 a la forme d'un arc de cercle dont le rayon de courbure C est fonction de la pression interne Pi du liquide 16. De manière générale, la pression P est hydrostatique, et définie par la formule suivante :

Pi = $\rho$gh     (équation 2)

$\rho$ étant la masse volumique du liquide,
g étant l'accélération de la pesanteur,
h étant la hauteur de liquide.

Si par suite d'une pression interne, hydrostatique ou autre, trop importante, le rayon de courbure C devient trop faible, le mouillage composite peut disparaître. Il est alors nécessaire de jouer sur la période L de la rugosité. La condition de mouillage composite devient alors :

R = T - $\frac{\pi}{2}$ - B     (équation 3)

l'angle B étant défini par la formule suivante :

sin B = $\frac{L}{2C}$     (équation 4)

On a représenté sur ces deux figures 3A et 3B l'angle de rugosité R défini par rapport à une normale à la paroi macroscopique 20 du creuset.

Dans des conditions particulières de l'apparition de ce phénomène de mouillage composite, on s'aperçoit que l'on peut diminuer presque totalement la surface de contact entre le liquide 16 et la paroi du creuset 14. On peut démontrer, toujours dans certaines conditions, que, après une solidification de ce liquide 16, un détachement du solide ainsi formé pourrait s'effectuer sans encombres. On peut également démontrer que la solidification elle-même puisse avoir lieu sans pratiquement de contacts avec la paroi 14 du creuset.

L'invention consiste donc à solidifier des matériaux liquides, et plus particulièrement à obtenir des semi-conducteurs par cristallogénèse dans un creuset. Selon l'invention, la paroi 14 du creuset est constituée d'un matériau choisi en fonction du liquide à solidifier, cette paroi étant d'une rugosité d'un angle R suffisant pour permettre la réalisation d'un mouillage composite, tel que défini précédemment et d'un démouillage assurant la solidification sans contact du matériau à solidifier avec le creuset, et assurant également le décollement complet de ce matériau solidifié par rapport à la paroi 14 du creuset.

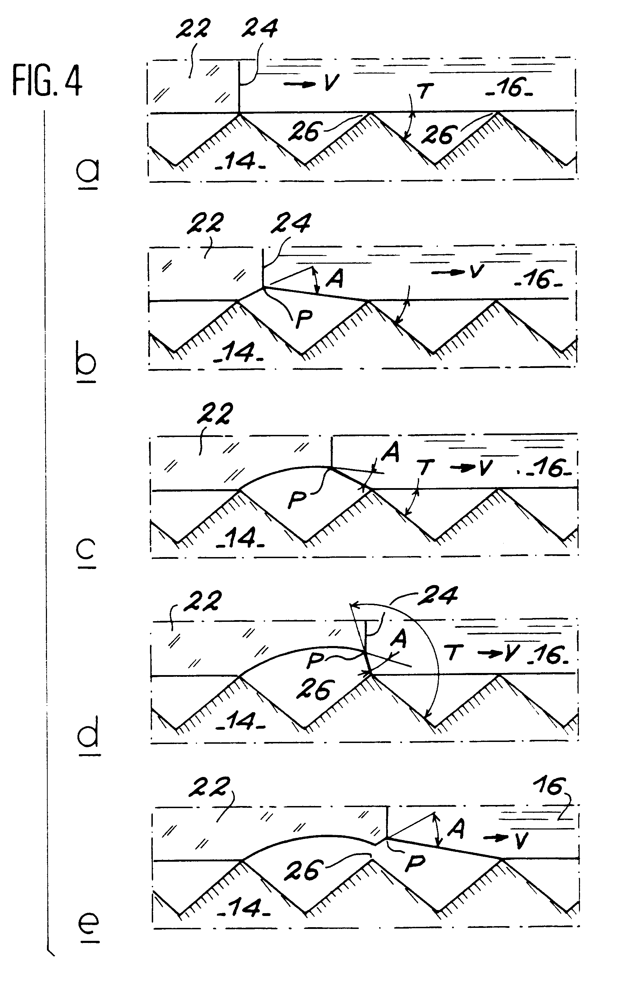

En effet, et en référence aux figures 4A à 4E, le phénomène de démouillage est maintenant expliqué à partir de la situation du mouillage composite représenté sur la figure 4A. Le phénomène de démouillage est lié à l'existence de l'angle de croissance A entre les surfaces libres du liquide 16 et du solide 22, au niveau de l'interface liquide-solide 24. On se place dans le cas où le liquide 16 est initialement positionné de manière à être en contact avec la paroi 14 du creuset, simplement au niveau des crêtes 26 de cette dernière. Etant donné l'existence de l'angle de croissance A pendant la solidification du materiau au niveau de son interface liquide-solide 24, le point triple P monte au-dessus de la ligne imaginaire reliant les sommets 26 des aspérités. Cette situation a été explicitée par la figure 4B.

Si la solidification se poursuit dans le sens de la flèche repérée V, symbolisant la vitesse de solidification de l'interface liquide-solide 24, la surface libre du solide ainsi formée affecte une forme particulière, celle-ci obéit à l'équation :

$$\frac{dy}{dx} \left( 1 - \frac{y}{x-L} + tgA \right) - \frac{y}{x-L} + tgA = 0 \quad (\text{équation 5})$$

En considérant maintenant la figure 4D, on voit que lorsque l'interface liquide-solide 24 arrive au niveau d'une crête 26, alors que le point triple P descend, la surface libre du liquide se trouve alors confrontée aux deux situations créées par l'existence d'un angle de croissance A au niveau de l'interface 24, et par l'existence de l'angle de mouillage T au niveau du contact du liquide 16 avec la crête 26. En considérant finalement la figure 4E, la solidification du liquide se prolongeant toujours selon la flèche V, le point triple P ne peut que remonter sans avoir été en contact avec la crête 26 de la paroi 14 du creuset. Ceci conduit en pratique au décollement du matériau du creuset.

La forme de la surface libre du solide 22 en représente alors l'intégration numérique de l'équation précédente dans des conditions particulières. Ces dernières sont l'angle de croissance A du matériau à

4

EP 0 338 914 B1

solidifier, l'angle de mouillage T de ce matériau vis-à-vis du matériau dont la paroi 14 du creuset est constituée, et la période L des aspérités de la paroi 14. Différents exemples de valeurs pour lesquels le résultat a été obtenu sont donnés plus loin. De plus, on montre que, en condition de microgravité, et si la rugosité de la paroi 14 peut être représentée par des dents de scie, le décollement du matériau apparaît quelle que soit la valeur non nulle de l'angle de croissance A. En pratique, étant donné un niveau résiduel de gravité et le fait que les rugosités sont plus ou moins arrondies, un angle de croissance A relativement élevé est nécessaire. Dans de telles conditions, ce phénomène dit de démouillage, est obtenu. Il est représenté par la figure 5.

Pour préciser les conditions particulières pour lesquelles le démouillage a lieu, on peut déjà préciser que l'angle de croissance A doit être élevé, la pression hydrostatique du fluide doit être faible. On en déduit que la hauteur du liquide ou que le niveau de gravité à appliquer lors de l'application de ce procédé, et plus particulièrement la cristallogénèse, doivent être faibles. Le procédé s'applique d'ailleurs plus facilement au cas de la solidification en microgravité de semi-conducteurs pour lesquels l'angle de croissance A est grand.

Le matériau à solidifier et le matériau constituant la paroi du creuset étant choisis, l'angle de mouillage T et l'angle de croissance étant donc également connus, l'intégration de la formule précédente permet de déduire des valeurs de fréquence de rugosité L pour lesquelles le phénomène de démouillage a lieu.

L'intégration de l'équation peut être calculée de manière analytique. C'est en particulier le cas lorsque les aspérités sont idéalement accentuées. Mais en général, il n'existe pas de solution analytique à cette équation. On trouve alors la forme de la surface du cristal par construction géométrique. Cette construction s'effectue de la manière suivante :
- à partir de la configuration de mouillage composite on suppose l'interface solide-liquide à la limite entre le creuset et le liquide ;
- on avance cette interface d'une très petite longueur Δ X. La surface libre du solide ainsi générée est déterminée en respectant les conditions suivantes ;
  . l'angle A entre la surface solide et la surface liquide ;
  . l'angle de mouillage T entre le liquide et l'aspérité ;
  . la surface du liquide est une droite ou un cercle de rayon R = 2σ/ρ gh, σ étant la tension superficielle du liquide, h la hauteur de liquide, et ρ la masse volumique du liquide ;
- on recommence ensuite à déplacer l'interface d'une très petite longueur Δ x, pour construire petit à petit la surface libre du solide.

La petite distance de déplacement Δ x doit être suffisamment faible pour que l'erreur de construction soit négligeable. On peut avantageusement automatiser la construction géométrique en programmant les diverses étapes sur un ordinateur.

Des essais ont été effectués lors de vols spatiaux. Une de ces expériences a été effectuée avec de l'antimoniure d'indium InSb, en creuset de quartz rugueux. La rugosité de ce creuset était nettement plus élevée dans certaines zones bien déterminées de celui-ci. Il est apparu que seules les zones de rugosité importante ont permis un démouillage du cristal et du creuset. Pour cette expérience les valeurs numériques étaient :

Angle de mouillage InSb-silice : 140°
Angle de croissance d'InSb : 30°
Rugosité moyenne du creuset : 68°
Rugosité des zones perturbées : 45°
Tension de surface : 0,42 N/m
Densité : 6,5 g/cm³
Hauteur de liquide : 40 mm
Période de la rugosité : 100 μm.

L'application des conditions de mouillage composite montre que celui-ci n'est possible dans l'espace que pour un angle de rugosité inférieur à 50°, et au sol inférieur à 31°. L'angle de croissance A est alors suffisamment élevé pour permettre le démouillage.

Une autre expérience de solidification d'antimoinure d'indium a été effectuée au sol. Elle portait sur la solidification horizontale d'une goutte allongée de hauteur égale à 5 mm. Le creuset était en graphite, ce qui donnait un angle de mouillage T = 150°. Il était usiné par un filetage d'angle de 27° et des pas de 500 micromètres. On a de plus constaté que, dans ce type d'expérience, le mouillage composite apparaît pour une rugosité d'angle inférieur à 40°.

La détermination de la rugosité minimale nécessaire se fait par calcul, à l'aide des équations 1, 2, 3 et 4, à condition de connaître des paramètres physiques des matériaux mis en jeu, c'est-à-dire l'angle de mouillage T liquide-creuset et l'angle de croissance A du cristal. Pour une application terrestre, la connaissance de la tension superficielle et de la densité du liquide est également nécessaire. Il est prévu de réaliser des rugosités plus fortes que celles calculées, afin de garantir de manière quasicertaine le démouillage.

L'exécution de la rugosité sur la paroi interne du creuset peut s'effectuer de deux manières différentes. La première consiste à mouler le creuset dans un moule lui-même rugueux, la deuxième consistant à utiliser des matériaux naturellement rugueux, ou rendus rugueux par marquage, emboutissage, etc, soit à partir d'un creuset lisse par enlèvement ou ajout de matière. Pour enlever de la matière, on peut utiliser toutes les méthodes classiques d'usinage, telles que le tournage, l'alésage, le filetage et le fraisage. Il est également possible d'utiliser le sablage en utilisant des particules de granulométrie compatible avec la rugosité à obtenir. Des rainures longitudinales ou transversales, en hélice, ou des trames plus ou moins régulières peuvent ainsi être formées sur la paroi interne du creuset. L'ajout de matière peut être obtenu par projection et collage de petites particules de granulométrie adéquates, technique appelée shoopage. Cet ajout de matière peut également être obtenu par apport d'une structure rugueuse telle que des fibres, des tissus, des ressorts, dont la géométrie est choisie pour entraîner le décollement du lingot de cristal lors du refroidissement.

Si les conditions de traitement et de fabrication exigent l'utilisation d'un matériau de creuset dont l'angle de mouillage avec le liquide est inférieur ou égal à 90°, il est possible de revêtir le creuset, avant ou après la réalisation de la rugosité, d'une couche ou d'un film permettant d'obtenir un angle de mouillage supérieur. Cette mesure permet de faciliter les conditions d'application de l'invention.

Néanmoins l'application industrielle principale de l'invention concerne la cristallogénèse de semi-conducteurs. Les différents cas envisagés sont : la cristallogénèse dans l'espace, pour toutes méthodes mettant en oeuvre un creuset, la cristallogénèse au sol pour toutes méthodes ne mettant en oeuvre que des hauteurs faibles de liquides. Il a été dit précédemment que les matériaux cristallisés doivent présenter un angle de croissance A suffisamment élevé pour que le phénomène de démouillage se produise. Les différents matériaux suivants remplissent cette condition :

Métaux (Al, Cu) : 1 à 2°
Silicium : 10 à 11°
Germanium : 15°
InSb : 30°
GaAs : 40°

Les matériaux composant le creuset sont en général la silice, le nitrure de bore, le graphite.

L'angle de mouillage doit nécessairement être supérieur à 90° et peut être mesuré préalablement par la méthode connue dite de la goutte posée. Il est bien évident que tout matériau compatible chimiquement avec l'opération à réaliser, et dont l'angle de mouillage avec le liquide est supérieur à 90°, pourra être utilisé.

L'avantage principal de l'invention est de permettre, grace à la rugosité de la paroi interne du creuset, le décollement du solide vis-à-vis du creuset et d'éliminer ainsi les dislocations généralement associées à ce collage. De plus, la diminution de la surface de contact entre le creuset et le liquide permet de diminuer la pollution chimique, ainsi que les problèmes thermiques.

L'invention permet donc l'utilisation de creusets pour la cristallogénèse dans l'espace, avec les avantages qui s'y rattachent et qui sont une mise en forme du cristal et l'élimination des surfaces libres génératrices de convection.

L'invention est applicable évidemment sur terre, tant que les pressions hydrostatiques au sein du matériau liquide sont suffisamment faibles, ce qui entraîne une hauteur de liquide modérée.

**Revendications**

1. Procédé de solidification d'un matériau liquide, tel que la cristallogénèse de semi-conducteurs, dans un creuset, procédé selon lequel connaissant (i) l'angle de mouillage (T) existant entre le matériau liquide (16) et la paroi (14) du creuset et (ii) l'angle de croissance (A) non nul du matériau à solidifier, on détermine pour le creuset :
   - la période de rugosité (L) et
   - un angle maximal (R) de la rugosité par rapport à une normale à la paroi macroscopique du creuset permettant de réaliser un mouillage composite entre le liquide (16) et la paroi interne (14) du creuset ,

on réalise ledit mouillage composite avec l'une ou l'autre des conditions :

$$R < T - \frac{\Pi}{2},$$

lorsque la pression hydrostatique du liquide est négligeable,

ou $R = T - \frac{\pi}{2} - B$,

avec $\sin B = \frac{L}{2C}$ , C étant le rayon de courbure de la surface libre du liquide entre deux aspérités du creuset,

puis on réalise un démouillage du creuset lors de la solidification du liquide (16), le matériau liquide étant choisi de manière à ce que le cristal solidifié possède un angle de croissance (A) suffisant pour assurer son décollement complet par rapport à la paroi interne (14) du creuset.

2. Procédé selon la revendication 1, caractérisé en ce que la rugosité ayant une période (L), l'intégration de l'équation suivante :

$$\frac{dy}{dx} \left(1 - \frac{y}{x-L} + tgA\right) - \frac{y}{x-L} + tgA = 0$$

définit la forme de la surface libre du matériau solidifié.

3. Creuset pour la mise en oeuvre du procédé selon l'une quelconque des revendications 1 ou 2, caractérisé en ce que la rugosité de la paroi interne (14) est obtenue par usinage par enlèvement de matière et que la période (L) de cette rugosité est définie par l'intégration de l'équation suivante :

$$\frac{dy}{dx} \left(1 - \frac{y}{x-L} + tgA\right) - \frac{y}{x-L} + tgA = 0$$

4. Creuset pour la mise en oeuvre du procédé selon l'une quelconque des revendications 1 ou 2, caractérisé en ce que la rugosité de la paroi interne (14) est obtenue par ajout ou collage de matière et que la période (L) de cette rugosité est définie par l'intégration de l'équation suivante :

$$\frac{dy}{dx} \left(1 - \frac{y}{x-L} + tgA\right) - \frac{y}{x-L} + tgA = 0$$

5. Application d'un creuset selon l'une quelconque des revendications 3 ou 4 pour la cristallogénèse de semi-conducteurs.

**Claims**

1. Method of solidifying a liquid material, such as the crystal growth of semiconductors, in a crucible, according to which method knowing (i) the wetting angle (T) existing between the liquid material (16) and the wall (14) of the crucible and (ii) the non-zero growth angle (A) of the material to be solidified, a determination is made, for the crucible, of:
   - the rugosity period (L) and
   - a maximum angle (R) of the rugosity in relation to a normal to the macroscopic wall of the crucible making it possible to produce composite wetting between the liquid (16) and the inner wall (14) of the crucible,
   the said composite wetting is produced with one or other of the conditions:

   $R < T - \frac{\pi}{2}$ ,

   when the hydrostatic pressure of the liquid is negligible,
   or $R = T - \frac{\pi}{2} - B$,
   with $\sin B = L/2C$, C being the radius of curvature of the free surface of the liquid between two asperities of the crucible,

and then dewetting of the crucible is produced during the solidification of the liquid (16), the liquid material being chosen so that the solidified crystal possesses a growth angle (A) sufficient to ensure its complete separation in relation to the inner wall (14) of the crucible.

2. Method according to Claim 1, characterized in that, with the rugosity having a period (L), the integration of the following equation

$$\frac{dy}{dx} \left(1 - \frac{y}{x-L} + tanA\right) - \frac{y}{x-L} + tanA = 0$$

defines the shape of the free surface of the solidified material.

3. Crucible for the implementation of the method according to either of Claims 1 and 2, characterized in that the rugosity of the inner wall (14) is obtained by machining, by removal of material, and in that the period (L) of this rugosity is defined by the integration of the following equation:

$$\frac{dy}{dx} \left(1 - \frac{y}{x-L} + tanA\right) - \frac{y}{x-L} + tanA = 0$$

4. Crucible for the implementation of the method according to either of Claims 1 and 2, characterized in that the rugosity of the inner wall (14) is obtained by addition or bonding of material and in that the period (L) of this rugosity is defined by the integration of the following equation:

$$\frac{dy}{dx} \left(1 - \frac{y}{x-L} + tanA\right) - \frac{y}{x-L} + tanA = 0$$

5. Application of a crucible according to either of Claims 3 and 4 for the crystal growth of semiconductors.

**Patentansprüche**

1. Verfahren, einen flüssigen Stoff in einem Tiegel erstarren zu lassen, wie etwa die Kristallzüchtung von Halbleitern, wonach, wenn
   (i) der Benetzungswinkel (T), der zwischen dem flüssigen Stoff (16) und der Tiegelwand (14) besteht, und
   (ii) der von Null verschiedene Wachstumswinkel (A) des zu verfestigenden Materials bekannt ist,
   für den Tiegel
   - die Periode der Unebenheit (L) und
   - ein maximaler Winkel (R) der Unebenheit gegenüber einer Normalen zur makroskopischen Wand des Tiegels bestimmt wird, die es gestatten, eine zusammengesetzte Benetzung zwischen der Flüssigkeit (16) und der inneren Tiegelwand (14) zu erhalten,
   die besagte zusammengesetzte Benetzung unter der einen oder der anderen der Bedingungen

$R < T - \pi/2$ ,

wenn der hydrostatische Druck der Flüssigkeit zu vernachlässigen ist, oder

$R = T - \pi/2 - B$ ,

mit sin $B$ = $L/2C$, wobei $C$ der Krümmungsradius der freien Flüssigkeitsoberfläche zwischen zwei Unebenheiten des Tiegels ist, erhalten wird,

und dann eine Entnetzung des Tiegels bei der Erstarrung der Flüssigkeit (16) erhalten wird, wobei der flüssige Stoff derart gewählt ist, daß der erstarrte Kristall einen Wachstumswinkel (A) besitzt, der ausreicht, um seine vollständige Ablösung von der inneren Tiegelwand (14) sicherzustellen.

2.  Verfahren nach Anspruch 1, dadurch gekennzeichnet, daß, wenn die Unebenheit eine Periode (L) besitzt, die Integration der folgenden Gleichung:

$$\frac{dy}{dx} \left( 1 - \frac{y}{x-L} + tgA \right) - \frac{y}{x-L} + tgA = 0$$

die Gestalt der freien Oberfläche des erstarrten Stoffes festlegt.

3.  Tiegel zur Durchführung des Verfahrens nach einem der Ansprüche 1 oder 2, dadurch gekennzeichnet, daß die Unebenheit der inneren Wand (14) durch eine Material abtragende Bearbeitung erhalten wird und daß die Periode (L) dieser Unebenheit durch die Integration der folgenden Gleichung gegeben ist:

$$\frac{dy}{dx} \left( 1 - \frac{y}{x-L} + tgA \right) - \frac{y}{x-L} + tgA = 0 \qquad .$$

4.  Tiegel zur Durchführung des Verfahrens nach einem der Ansprüche 1 oder 2, dadurch gekennzeichnet, daß die Unebenheit der inneren Wand (14) durch Hinzufügen oder Ankleben von Material erhalten wird und daß die Periode (L) dieser Unebenheit durch die Integration der folgenden Gleichung gegeben ist:

$$\frac{dy}{dx} \left( 1 - \frac{y}{x-L} + tgA \right) - \frac{y}{x-L} + tgA = 0 \qquad .$$

5.  Anwendung eines Tiegels nach einem der Ansprüche 3 oder 4 auf die Kristallzüchtung von Halbleitern.

FIG. 1

FIG. 2

FIG. 5

FIG. 3 a

FIG. 3 b

EP 0 338 914 B1

FIG. 4

12